# FASCICULE DE BREVET EUROPEEN

(11) **EP 4 492 598 B1**
(45) Date de publication et mention de la délivrance du brevet: **13.05.2026**
(21) Numéro de dépôt: 24182651.0
(22) Date de dépôt: 17.06.2024
(51) Int. Cl.: H02H 3/347, G01R 31/52, H02H 3/16

(54) **PROCÉDÉ DE VÉRIFICATION DE L'ADÉQUATION AUX COURANTS RÉSIDUELS DE DISJONCTEURS DIFFÉRENTIELS**
VERFAHREN ZUR ÜBERPRÜFUNG DER EIGNUNG FÜR RESTSTRÖME VON DIFFERENTIALSCHUTZSCHALTERN
METHOD FOR CHECKING THE RESIDUAL CURRENT SUITABILITY OF DIFFERENTIAL CIRCUIT BREAKERS

(30) Priorité: 22.06.2023 FR 2306448
(43) Date de publication de la demande: 15.01.2025
(73) Titulaire: Chauvin Arnoux, 92600 Asnieres-sur-Seine (FR)
(72) Inventeur: PALANCHE, Denis, 92600 ASNIERES-SUR-SEINE (FR); PILLIAS, Benoît, 92600 ASNIERES-SUR-SEINE (FR)
(74) Mandataire: Cabinet Beau de Loménie

(56) Documents cités:
- WO-A1-2021/259922
- JP-A- 2006 184 242
- JP-A- 2009 168 664
- JP-U- H0 657 035
- JP-U- H0 716 176

## Description

### Domaine Technique

La présente invention se rapporte au domaine de la surveillance des appareils et installations électriques par une protection différentielle consistant à comparer les courants entrant et sortant de ces appareils et installations, afin d'assurer la protection des personnes face au contact direct électrique résultant d'un défaut de ces appareils ou installations et elle concerne plus particulièrement un procédé permettant de vérifier la bonne adéquation de cette protection différentielle avec les courants de fuite ou résiduels émanant de ces appareils et installations.

### Technique antérieure

La protection différentielle est mise en œuvre dans les installations électriques au travers de deux familles de dispositifs, à savoir les interrupteurs différentiels et les disjoncteurs différentiels, ces derniers par nature très sélectifs (c'est à dire sensibles mais pas trop) intégrant en plus la détection des surintensités afin d'assurer à la fois la protection contre le défaut à la terre et les surcharges.

L'utilisation de plus en plus généralisé d'électronique de puissance dans les sources d'alimentation, dans leur commande mais aussi dans les produits alimentés a conduit à l'apparition de courants résiduels de nature et de forme complexes, avec, selon les cas une composante continue, des composantes fréquentielles basse mais aussi haute fréquence.

Aussi, la norme internationale IEC 60755 et son équivalent allemand VDE 0664-100 définissent principalement quatre familles de disjoncteurs différentiels selon la nature de leur déclenchement : le type AC lorsque ce déclenchement est assuré par un courant alternatif sans composante continue, le type A lorsqu'un courant pulsé superposé à une composante continue d'au plus 6mA peut aussi assurer ce déclenchement, le type F lorsque cette composante continue est d'au plus 10 mA et que des courants composites peuvent également assurer ce déclenchement et le type B/B+ lorsqu'un courant continu ou un courant résiduel haute fréquence (éventuellement supérieur à 420mA pour le type B+) peuvent en plus assurer ce déclenchement. Par haute fréquence, on entend une fréquence allant jusqu'à 1 kHz.

Dans certains cas, des perturbations résultant du réseau ou de son environnement peuvent induire un déclenchement intempestif du disjoncteur différentiel qui entraine des coupures de l'alimentation électrique en l'absence de situation de danger. Ce type de déclenchement, souvent répétitif, est très préjudiciable à la qualité de la fourniture de l'énergie et entraine pour l'utilisateur des pertes d'exploitation. Ces perturbations peuvent aussi entrainer un non déclenchement en présence de défaut et donc de danger dû à une baisse de la sensibilité dans la détection des courants de défaut dangereux. Cette situation ne doit pas être négligée car elle affecte la sécurité.

Parmi les principaux types de perturbations pouvant entrainer des déclenchements intempestifs, on notera particulièrement :
- Les courants de fuite permanents d'autant plus élevés que l'installation électrique est importante. Dans toute installation électrique, il y a un courant de fuite permanent à la terre dû soit aux déséquilibres des capacités de fuite naturelles des conducteurs actifs à la terre (circuits triphasés), soit à des capacités entre une phase et la terre pour des circuits monophasés pouvant avoir pour origine les condensateurs de filtrage reliés à la masse de certains équipements électroniques (automatismes, systèmes de communication, réseaux informatiques, etc.).
- Les courants de fuite à composante haute fréquence présents sous la forme d'harmoniques ou de transitoires (résultant par exemple de commutations à la mise sous tension) et qui peuvent avoir pour origine les alimentations d'équipements informatiques, les convertisseurs de fréquence, les commandes de moteur par variateur de vitesse, les systèmes d'éclairage à lampes fluorescentes. Ils peuvent aussi provenir de la proximité avec des appareils de coupure à moyenne tension et de batterie de condensateurs pour la compensation de l'énergie réactive.

Parmi les principaux types de perturbations pouvant entrainer un non déclenchement, il y a particulièrement :
- Les courants permanents à composante continue ainsi que les courants permanents à composante très basse fréquence (typiquement inférieur à quelques Hz). Si ces courants, par nature, représentent de faibles ou moindres risques au regard de la protection des personnes, leurs capacités à saturer le tore magnétique qui est l'élément actif dans la détection des courants différentiels, conduisent à l'inefficacité par aveuglement de certains disjoncteurs différentiels.
- La température qui peut impacter les éléments mécaniques du disjoncteur.

Ainsi, pour fonctionner dans des conditions de sécurité optimales sans déclenchements intempestifs ou non-déclenchement, les disjoncteurs différentiels doivent être traversés par des courants résiduels de formes bien spécifiques en fonction de leur type (AC, A, F, B/B+).

Or, à ce jour, les seuls dispositifs de mesure existants ne sont pas capables de déterminer simplement cette adéquation. Il s'agit en effet soit de simples appareils portatifs, du type pinces de courants de fuite sans gestion de la composante continue, soit d'appareils fixes, du type contrôleurs d'isolement, installés en tête de l'installation électrique dans laquelle est injectée un signal de contrôle, soit encore de centrales d'analyse et d'expertise particulièrement complexe d'utilisation même pour un technicien chevronné.

Exemples de dispositifs de verification de la protection différentielle sont divulgués dans les publications JP 2006-184242 A, JP H0716176 U, JP H0657035 U et WO 2021/259922 A1.

### Exposé de l'invention

L'invention, telle que définie par le jeux de revendications ici-joint, a donc pour objet de pallier ce manque en proposant un procédé et un équipement portatif simple d'utilisation permettant d'analyser la bonne adéquation des disjoncteurs différentiels avec les courants résiduels qui les traversent en l'absence de défauts.

Ces buts sont atteints par un procédé de vérification de l'adéquation aux courants résiduels d'un disjoncteur différentiel disposé en tête d'une installation électrique, au moyen d'une pince de mesure de courant de fuite enserrant les conducteurs actifs sortant du disjoncteur différentiel pour alimenter une pluralité d'appareils électriques, procédé consistant à :
- acquisition sur une durée totale d'acquisition (t_{fin} - t_{début}), à une fréquence d'échantillonnage déterminée, d'échantillons de courants résiduels pendant des périodes d'acquisition successives,
- analyse fréquentielle par FFT de ces échantillons de courants résiduels dans des bandes de fréquences prédéterminées,
- détermination pour chaque bande de fréquences et pour chacune des périodes d'acquisition successives, d'un courant efficace maximum et, à l'issue de la durée totale d'acquisition, enregistrement de la valeur maximale des courants efficaces maximums ainsi déterminés dans chaque bande de fréquence, et
- disqualification ou non du disjoncteur différentiel selon que cette valeur maximale des courants efficaces maximums répond ou non à une condition de compatibilité prédéterminée et affichage de cette disqualification ou non en mode binaire par un pictogramme sur la pince de mesure de courant de fuite.

Ainsi, ce procédé mis en œuvre par une pince de mesure dont le module de traitement est spécialement configuré à cet effet, peut être utilisé en toute sécurité pour l'utilisateur, ne nécessite ni intervention mécanique (démontage, déconnexion,...), ni interruption de l'alimentation en énergie et ne présente donc aucun risque de dégradation potentielle pour l'installation électrique.

Selon un mode de réalisation préférentiel, les bandes de fréquences prédéterminées sont les quatre suivantes : DC ; ]DC - 50Hz[ ; ]60Hz - 1kHz] et ]1kHz - 10kHz].

De préférence, le calcul de la FFT est réduit en ne la déterminant que jusqu'à 1kHz, la bande de fréquences ]1kHz - 10kHz] étant calculée par soustraction quadratique entre le courant efficace total obtenu sur la plage entière de fréquences [DC - 10kHz] et la somme des échantillons de courants résiduels obtenus dans la bande de fréquences ]DC - 1kHz].

Avantageusement, le calcul de FFT est précédé d'un fenêtrage de Hanning ou de Hamming appliqué à un nombre déterminé d'échantillons de courants résiduels.

De préférence, l'utilisation d'un disjoncteur différentiel de type AC, A, ou F qui n'est pas recommandé est affichée sur la pince de mesure de courant de fuite respectivement par les pictogrammes suivants :

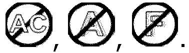

Avantageusement, la valeur maximale de courant dans chacune des bandes de fréquences définissant la condition de compatibilité prédéterminée et entrainant la disqualification du disjoncteur différentiel est donnée par le tableau suivant :

| ***DC*** | ***]DC - 50Hz[*** | ***]6OHz - 1kHz]*** | ***>1kHz*** | ***Icones affichées*** |
|---|---|---|---|---|
| *>1mA et <6mA* | indifférent | indifférent | indifférent | 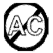 |
| ≥ *6mA et <10mA* | indifférent | indifférent | indifférent | 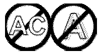 |
| ≥ *10mA* | indifférent | indifférent | indifférent | 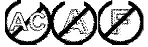 |
| indifférent | >1mA | indifférent | indifférent | 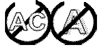 |
| indifférent | indifférent | >1mA | indifférent | 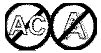 |
| | | ≤ IΔn | | |
| indifférent | indifférent | > IΔn | indifférent | 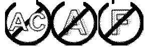 |

De préférence, le courant efficace total est calculé par simple addition quadratique de l'ensemble des échantillons de courants résiduels.

Avantageusement, le courant DC est calculé en effectuant une moyenne des échantillons de courants résiduels.

De préférence, chaque période d'acquisition a une durée fixe de 100 ms, la fréquence d'échantillonnage est de 81,92kHz et le nombre déterminé d'échantillons pour le calcul de la FFT est de 512.

L'invention concerne également une pince de mesure de courant de fuite comportant un capteur de courant AC+DC apte à mesurer des courants AC ou DC à partir de 1mA, sur une bande de fréquences comprise entre 0Hz et 10kHz minimum, et un module de traitement spécialement configuré pour mettre en œuvre le procédé précité.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur lesquels :
[Fig. 1] la figure 1 illustre un exemple schématique d'installation électrique domestique à laquelle est appliqué le procédé de vérification de disjoncteurs différentiels selon l'invention,
[Fig. 2] la figure 2 montre les différentes étapes du procédé de vérification de disjoncteurs différentiels selon l'invention, et
[Fig. 3] la figure 3 montre en détail l'étape d'analyse fréquentielle par FFT des courants résiduels du procédé de la figure 2.

### Description des modes de réalisation

Le principe de l'invention repose sur un procédé permettant de qualifier une protection différentielle standard de type AC, A, F, B/B+ mise en œuvre dans une installation électrique, c'est-à-dire de diagnostiquer ou de mettre en évidence dans cette installation dépourvue de défauts, une inadéquation de cette protection différentielle au regard des courants résiduels présents dans cette installation.

Ce procédé de vérification consiste, en enserrant l'ensemble des conducteurs actifs en tête d'un disjoncteur différentiel, à identifier les disjoncteurs différentiels non compatibles avec les courants résiduels mesurés et à fournir, sous forme d'un pictogramme, simple indicateur binaire, un verdict d'inadéquation (ou de non compatibilité) de la protection différentielle installée. Il pourra de plus intégrer la visualisation des principales causes d'inadéquation constatés ou/et mesurées.

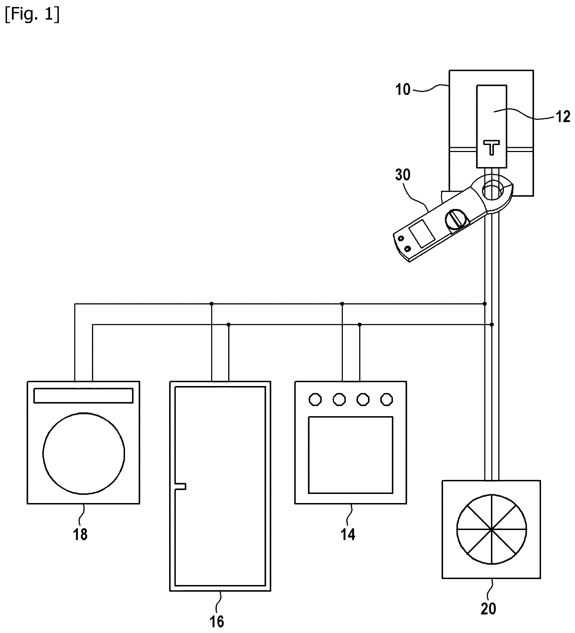

La figure 1 montre un exemple d'une installation électrique domestique dont le tableau électrique 10 comporte un disjoncteur différentiel 12 à tester.

Le disjoncteur différentiel est relié à différents appareils électriques dont il assure la protection, par exemple : un four électrique 14, un réfrigérateur 16, une machine à laver 18 tous alimentés en monophasé et une pompe à chaleur à onduleur 20 alimentée en triphasé. L'installation est supposée en fonctionnement et sans défaut comme mentionné précédemment (l'invention n'a pas de sens dans une installation défectueuse).

Selon l'invention, le procédé de vérification de l'adéquation de ce disjoncteur différentiel 12 aux courant résiduels le traversant est mise en œuvre dans cette installation au moyen d'un dispositif de mesure 30 enserrant l'ensemble des conducteurs actifs (phase(s) + neutre) connectés en sortie du disjoncteur différentiel. Un tel dispositif de mesure est par exemple une pince de mesure de courants de fuite telle que décrite dans la demande FR2206239 déposée au nom de la demanderesse, comportant un capteur de courant de fuite AC+DC pouvant mesurer avec précision des courants AC ou DC à partir de 1mA, sur une bande de fréquences comprise entre 0Hz et 10kHz minimum, dont le module de traitement des mesures est spécialement configuré pour mettre en œuvre ce procédé innovant.

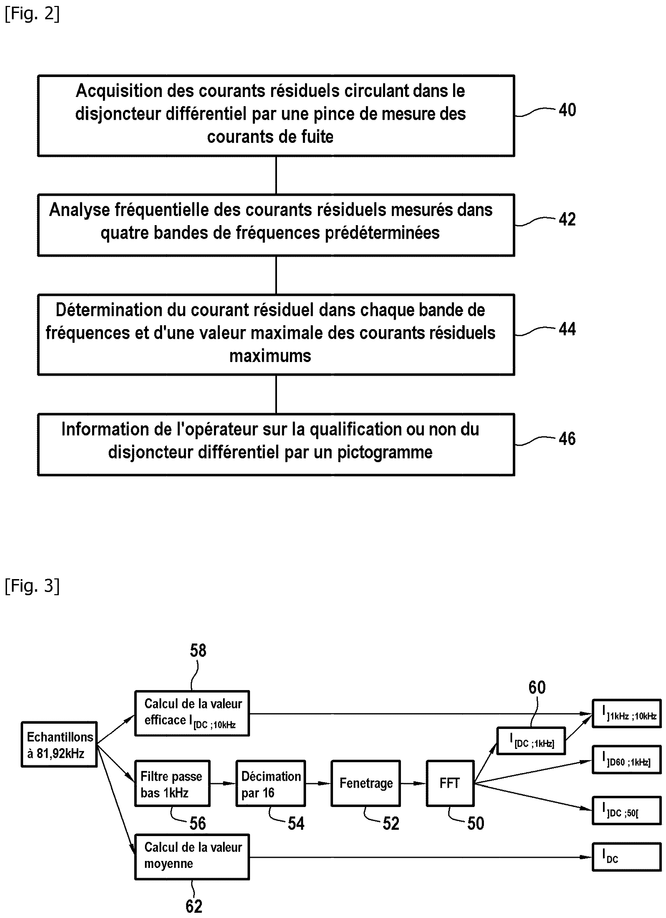

Les différentes étapes de ce procédé sont illustrées à la figure 2.

Une fois la pince de mesure 30 mise en place par l'opérateur de façon à enserrer l'ensemble des conducteurs actifs (phase(s) + neutre) sortant du disjoncteur différentiel 12, la première étape 40 du procédé consiste à effectuer sur une durée totale d'acquisition définie par l'opérateur (comme il sera détaillé plus avant) des acquisitions successives, par exemple par période de 100ms, du courant résiduel présent dans l'installation et circulant dans ce disjoncteur différentiel.

Dans une seconde étape 42, les courants résiduels mesurés font l'objet d'une analyse fréquentielle dans quatre bandes de fréquences prédéterminées : DC ; ]DC - 50Hz[ ; ]60Hz - 1kHz] et ]1kHz - 10kHz]. DC signifiant la fréquence 0Hz et les crochets ouverts ou fermés signifiant respectivement une exclusion ou une inclusion de la fréquence frontière de la plage de fréquence associée.

Puis, dans une étape suivante 44, pour chaque période d'acquisition et dans chaque bande de fréquences, un courant efficace maximum (Imax_{DC}, Imax_{]DC-50Hz[}, Imax_{]60Hz} - _{1kHz]}, Imax_{]1kHz - 10kHz]}) correspondant à la valeur maximale des courants résiduels mesurés dans une bande de fréquence déterminée et pour une période d'acquisition déterminée, est calculé et enregistré en mémoire. A l'issue de la durée totale d'acquisition, la valeur maximale (maximum maximorum) de ces courants efficaces maximums est enregistrée à son tour.

Enfin, dans une quatrième et dernière étape 46, cette valeur maximale des maximums des courants efficaces obtenus dans chaque bande de fréquences est utilisée comme une condition de compatibilité pour ségréger les différents types de disjoncteurs différentiels conformément aux normes précitées et donc disqualifier tel ou tel disjoncteur en en informant l'opérateur par un simple signal binaire pouvant être matérialisé typiquement par un pictogramme ou une icône. Toutefois, afin de ne pas faire attendre l'opérateur si, par exemple, on sait déjà que le disjoncteur AC n'est pas compatible, il est possible d'effectuer cette étape de ségrégation et l'étape d'affichage des pictogrammes qui sera détaillée plus avant en même temps que le calcul du maximum des maximums, c'est-à-dire en particulier tous les 100ms.

Pour éviter une problématique d'aveuglement sur certain disjoncteur différentiel en présence de courant > 1kHz, il est aussi possible d'informer l'opérateur sur la valeur du courant dans cette bande et, si ce courant est important, de lui recommander de ne pas utiliser de disjoncteur de type AC.

La durée totale d'acquisition des mesures (t_{fin} - t_{début}) et donc de l'analyse fréquentielle correspondante dépend de la nature des charges connectées sur le disjoncteur différentiel 12. C'est à l'opérateur d'estimer cette durée car c'est lui qui a la connaissance de la nature des charges connectées sur le disjoncteur différentiel. L'objectif est de pouvoir enregistrer tous les modes de fonctionnement des appareils. Quelques exemples illustratifs sont donnés dans le tableau ci-dessous :

| **Type de charge** | | **Durée totale d'acquisition** |
|---|---|---|
| charge domotique (ordinateur, luminaire, volet roulant...) | | < 1 minute |
| Système à compresseur : | | 10 minutes |
| | - Réfrigérateur, congélateur | |
| | - PAC ancienne génération | |
| Système piloté en fréquence variable : | | < 1minute |
| | - PAC nouvelle génération avec onduleur | |
| | - Réfrigérateur nouvelle génération avec onduleur | |
| | - Four vapeur avec onduleur | |
| | - Chargeur de batterie de voiture | |
| Electroménager | | 60 minutes |
| | - Machine à laver le linge | |

La première étape d'acquisition des mesures de courant est plus précisément détaillée ci-après.

Les signaux analogiques issus du capteur de courant sont échantillonnés grâce à un convertisseur analogique numérique du module de traitement de la pince de mesure. La fréquence d'échantillonnage doit être définie de manière à pouvoir acquérir la fréquence la plus élevée. Par exemple, pour mesurer avec précision le 10kHz, il convient de choisir une fréquence d'échantillonnage d'au moins 50kHz. De même, la durée de l'acquisition doit au moins être supérieure à une période du réseau électrique (soit 20ms pour le 50Hz et 16,66ms pour le 60Hz). Cette durée peut être variable en fonction de la période réseau mesurée, mais elle est de préférence fixe pour des raisons de simplicité et de robustesse. Typiquement, une durée fixe égale à 100ms est préférée car elle représente un nombre entier de périodes à la fois pour le 50Hz (5 périodes) et pour le 60Hz (6 périodes). Ainsi, un échantillonnage à 50kHz permettrait de recueillir 5000 échantillons de mesure sur 100ms.

La seconde étape d'analyse fréquentielle est maintenant détaillée en référence à la figure 3. Celle-ci est réalisée par un algorithme de transformation de Fourrier rapide 50 (FFT pour « Fast Fournier Transform » en anglais) qui nécessite, pour un fonctionnement correct, un nombre d'échantillons multiple de n=2^{p}. La fréquence d'échantillonnage est donc choisie de préférence à 81,92kHz permettant ainsi l'obtention de 8192 échantillons du courant résiduel (n = 2¹³) sur la période de 100ms.

Un fenêtrage 52, de type Hanning ou Hamming par exemple, précède le calcul de la FFT afin d'obtenir un résultat plus lisse de la FFT. La durée du calcul dépend du nombre d'échantillons et est proportionnelle à n.log(n). La mémoire du module de traitement nécessaire à ce calcul est également proportionnelle à n. Aussi, pour réduire la taille de la mémoire nécessaire au stockage des échantillons et gagner en temps de calcul, il est choisi d'effectuer ce calcul de la FFT seulement jusqu'à 1Khz (bloc 56 de filtrage passe-bas) et aussi de ne prendre que 1 échantillon sur 16 (bloc de décimation 54) soit seulement 512 échantillons sur les 8192 recueillis.

Etant donné que le calcul de FFT ne doit porter que sur quatre bandes de fréquences, cette simplification du calcul par le module de décimation 54 et le recours au filtrage passe-bas 56 ne déterminant la FFT que jusqu'à 1kHz, permet de calculer la bande de fréquences ]1kHz - 10kHz] par soustraction quadratique entre le courant efficace total (bloc de calcul 58) obtenu sur la plage entière de fréquences [DC - 10kHz] et la somme des échantillons de la FFT (bloc de calcul 60) obtenu dans la bande de fréquences ]DC - 1kHz]. Le courant efficace total est calculé par simple addition quadratique de l'ensemble des échantillons. Le courant DC est aussi obtenu à partir de la FFT mais peut être calculé de manière plus précise en effectuant une moyenne des échantillons (bloc de calcul 62).

Cette technique innovante permet de réduire par environ 23 le temps de calcul de la FFT (au gain initial de temps de calcul de la FFT de 170 dû à la décimation, il faut rajouter le calcul du filtre passe-bas à 1kHz et la soustraction quadratique qui ramène ce ratio à environ 23) et donc comme indiqué précédemment de réduire la taille de la mémoire par 16.

La dernière étape du procédé permettant l'information de l'opérateur sur la disqualification ou non du disjoncteur différentiel testé est détaillée ci-après. En effet, le calcul de la valeur maximale des courants efficaces maximums dans les quatre bandes de fréquences permet, en fonction de son niveau de ségréger les 4 types de disjoncteur différentiel selon, par exemple la norme IEC 60755 (AC / A / F / B).

Pour cela, et ainsi simplifier le résultat d'analyse pour l'opérateur, il pourra être affiché selon un mode binaire ou tout ou rien, les pictogrammes suivants :
- 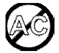 : l'utilisation de disjoncteur différentiel de type AC n'est pas recommandé
- 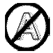 : l'utilisation de disjoncteur différentiel de type A n'est pas recommandé
- 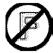 : l'utilisation de disjoncteur différentiel de type F n'est pas recommandé

Le tableau ci-dessous définit la valeur maximale de courant dans chaque bande de fréquences entrainant la disqualification de certains disjoncteurs différentiels :

| ***DC*** | ***]DC - 50Hz[*** | ***]60Hz - 1kHz]*** | ***>1kHz*** | ***Icones affichées*** |
|---|---|---|---|---|
| *>1mA et <6mA* | XXX | XXX | XXX | 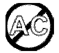 |
| ≥ *6mA et <10mA* | XXX | XXX | XXX | 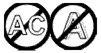 |
| ≥ *10mA* | XXX | XXX | XXX | 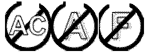 |
| XXX | >1mA | XXX | XXX | 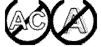 |
| XXX | XXX | >1mA | XXX | 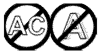 |
| | | ≤ IΔn | | |
| XXX | XXX | > IΔn | XXX | 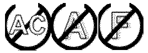 |

| | | | | |
|---|---|---|---|---|
| XXX = indifférent et IΔn une incertitude | | | | |

- Un seuil dépassé sur le courant DC entraine un problème de sécurité potentiel avec l'aveuglement et le non déclenchement de la protection différentielle en cas de défaut d'isolement,
- Un seuil dépassé sur les bandes de fréquences ]DC - 50Hz[ et ]60Hz - 1kHz] n'entraine pas de risque pour la sécurité mais de potentiel déclenchements non désirés,
- Un courant trop important dans la bande > 1kHz peut entrainer un problème de sécurité potentiel sur les disjoncteurs différentiels avec l'aveuglement et le non déclenchement de la protection différentielle en cas de défaut d'isolement.

On notera que, si dans l'exemple précité, la bande de fréquences supérieure à 1kHz n'est pas exploitée pour la sélection des disjoncteurs différentiels, rien n'empêche de le faire si le besoin s'en fait sentir notamment dans le cadre de la norme VDE 0664-100 ou toute autre à venir.

## Revendications

1. Procédé de vérification de l'adéquation aux courants résiduels le traversant d'un disjoncteur différentiel (12) disposé en tête d'une installation électrique (10), au moyen d'une pince de mesure de courant de fuite (30) enserrant les conducteurs actifs sortant du disjoncteur différentiel pour alimenter une pluralité d'appareils électriques (14, 16, 18, 20), procédé consistant à :
- acquisition sur une durée totale d'acquisition (t_{fin} - t_{début}), à une fréquence d'échantillonnage déterminée, d'échantillons de courants résiduels pendant des périodes d'acquisition successives,
- analyse fréquentielle par FFT de ces échantillons de courants résiduels dans des bandes de fréquences prédéterminées,
- détermination pour chaque bande de fréquences et pour chacune des périodes d'acquisition successives, d'un courant efficace maximum et, à l'issue de la durée totale d'acquisition, enregistrement de la valeur maximale des courants efficaces maximums ainsi déterminés dans chaque bande de fréquence, et
- disqualification ou non du disjoncteur différentiel selon que cette valeur maximale des courants efficaces maximums répond ou non à une condition de compatibilité prédéterminée et affichage de cette disqualification ou non en mode binaire par un pictogramme sur la pince de mesure de courant de fuite.

2. Procédé selon la revendication 1, dans lequel les bandes de fréquences prédéterminées sont les quatre suivantes : DC ; ]DC - 50Hz[ ; ]60Hz - 1kHz] et ]1kHz - 10kHz].

3. Procédé selon la revendication 2, dans lequel le calcul de la FFT est réduit en ne la déterminant que jusqu'à 1kHz, la bande de fréquences ]1kHz - 10kHz] étant calculée par soustraction quadratique entre le courant efficace total obtenu sur la plage entière de fréquences [DC - 10kHz] et la somme des échantillons de courants résiduels obtenus dans la bande de fréquences ]DC - 1kHz].

4. Procédé selon la revendication 3, dans lequel le calcul de FFT est précédé d'un fenêtrage de Hanning ou de Hamming appliqué à un nombre déterminé d'échantillons de courants résiduels.

5. Procédé selon l'une quelconque des revendications 1 à 5, dans lequel l'utilisation d'un disjoncteur différentiel de type AC, A, ou F qui n'est pas recommandé est affichée sur la pince de mesure de courant de fuite respectivement par les pictogrammes suivants :

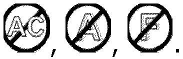

6. Procédé selon la revendication 4, dans lequel la valeur maximale de courant dans chacune des bandes de fréquences définissant la condition de compatibilité prédéterminée et entrainant la disqualification du disjoncteur différentiel est donnée par le tableau suivant :
| ***DC*** | ***]DC - 50Hz[*** | ***]60Hz - 1kHz]*** | ***>1kHz*** | ***Icones affichées*** |
|---|---|---|---|---|
| *>1mA et <6mA* | indifférent | indifférent | indifférent | 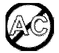 |
| ≥ 6*mA et <10mA* | indifférent | indifférent | indifférent | 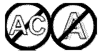 |
| ≥ 10*mA* | indifférent | indifférent | indifférent | 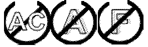 |
| indifférent | >1mA | indifférent | indifférent | 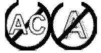 |
| indifférent | indifférent | >1mA | indifférent | 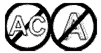 |
| | | ≤ IΔn | | |
| indifférent | indifférent | > IΔn | indifférent | 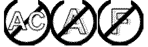 |

7. Procédé selon l'une quelconque des revendications 1 à 6, dans lequel le courant efficace total est calculé par simple addition quadratique de l'ensemble des échantillons de courants résiduels.

8. Procédé selon l'une quelconque des revendications 1 à 7, dans lequel le courant DC est calculé en effectuant une moyenne des échantillons de courants résiduels.

9. Procédé selon l'une quelconque des revendications 1 à 8, dans lequel chacune des périodes successives d'acquisition successives a une durée fixe de 100 ms, la fréquence d'échantillonnage est de 81,92kHz et le nombre déterminé d'échantillons pour le calcul de la FFT est de 512.

10. Pince de mesure de courant de fuite comportant un capteur de courant AC+DC apte à mesurer des courants AC ou DC à partir de 1mA, sur une bande de fréquences comprise entre 0Hz et 10kHz minimum, et un module de traitement spécialement configuré pour mettre en œuvre le procédé selon l'une quelconque des revendications 1 à 9.

## Patentansprüche

1. Verfahren zur Überprüfung der Eignung eines Fehlerstromschutzschalters (12), der am Eingang einer elektrischen Installation (10) angeordnet ist, für Restströme, die ihn durchlaufen, mittels einer Leckstrom-Messzange (30), welche die aktiven Leiter, die aus dem Fehlerstromschutzschalter austreten, um mehrere elektrische Geräte (14, 16, 18, 20) zu versorgen, einklemmt, wobei das Verfahren besteht aus:
- der Erfassung von Abtastungen von Restströmen während aufeinanderfolgender Erfassungsperioden, über eine Gesamterfassungsdauer (t_{fin} - t_{début}) und mit einer bestimmten Abtastfrequenz,
- der Frequenzanalyse dieser Abtastungen von Restströmen in vorbestimmten Frequenzbändern mittels FFT,
- der Bestimmung, für jedes Frequenzband und für jede der aufeinanderfolgenden Erfassungsperioden, eines maximalen Effektivstroms und, am Ende der Gesamterfassungsdauer, der Aufzeichnung des maximalen Werts der so bestimmten maximalen Effektivströme in jedem Frequenzband, und
- der Disqualifizierung des Fehlerschutzschalters oder nicht, je nachdem, ob dieser maximale Wert der maximalen Effektivströme einer vorbestimmten Kompatibilitätsbedingung entspricht oder nicht, und Anzeigen der Disqualifizierung oder nicht in dem binären Modus durch ein Piktogramm auf der Leckstrom-Messzange.

2. Verfahren nach Anspruch 1, wobei die vorbestimmten Frequenzbänder die folgenden vier sind: DC, ]DC - 50 Hz[, ]60 Hz - 1 kHz] und]1 kHz - 10 kHz].

3. Verfahren nach Anspruch 2, wobei die Berechnung der FFT reduziert wird, indem sie nur bis 1 kHz bestimmt wird, wobei das Frequenzband ]1 kHz - 10 kHz] durch quadratische Subtraktion zwischen dem gesamten Effektivstrom, der über den gesamten Frequenzbereich [DC - 10 kHz] erhalten wird, und der Summe der Abtastungen von Restströmen, die in dem Frequenzband ]DC - 1 kHz] erhalten wird, berechnet wird.

4. Verfahren nach Anspruch 3, wobei der Berechnung der FFT eine Hanning- oder Hamming-Fensterung vorausgeht, die auf eine bestimmte Anzahl von Abtastungen von Restströmen angewendet wird.

5. Verfahren nach einem der Ansprüche 1 bis 5, wobei die Verwendung eines Fehlerstromschutzschalters der Typen AC, A oder F die nicht empfohlen wird, auf der Leckstrom-Messzange jeweils durch die folgenden Piktogramme angezeigt wird:

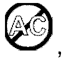

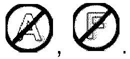

6. Verfahren nach Anspruch 4, wobei der maximale Stromwert in jedem der Frequenzbänder, der die vorbestimmte Kompatibilitätsbedingung definiert und zur Disqualifizierung des Fehlerstromschutzschalters führt, durch die folgende Tabelle angegeben wird:
| ***DC*** | ***]DC - 50 Hz[*** | ***]60 Hz-1 kHz]*** | ***>1 kHz*** | ***Angezeigte Symbole*** |
|---|---|---|---|---|
| *>1 mA und <6 mA* | nicht relevant | nicht relevant | nicht relevant | 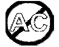 |
| *≥6 mA und <10 mA* | nicht relevant | nicht relevant | nicht relevant | 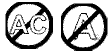 |
| ≥ 10 *mA* | nicht relevant | nicht relevant | nicht relevant | 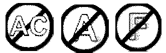 |
| nicht relevant | >1 mA | nicht relevant | nicht relevant | 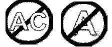 |
| nicht relevant | nicht relevant | >1 mA | nicht relevant | 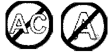 |
| | | ≤ IΔn | | |
| nicht relevant | nicht relevant | > IΔn | nicht relevant | 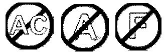 |

7. Verfahren nach einem der Ansprüche 1 bis 6, wobei der gesamte Effektivstrom durch einfache quadratische Addition der Gesamtheit der Abtastungen von Restströmen berechnet wird.

8. Verfahren nach einem der Ansprüche 1 bis 7, wobei der DC-Strom berechnet wird, indem ein Mittelwert der Abtastungen von Restströmen gebildet wird.

9. Verfahren nach einem der Ansprüche 1 bis 8, wobei jede der aufeinanderfolgenden Erfassungsperioden eine feste Dauer von 100 ms aufweist, wobei die Abtastfrequenz 81,92 kHz beträgt und die bestimmte Anzahl von Abtastungen für die Berechnung der FFT 512 beträgt.

10. Leckstrom-Messzange, die einen AC+DC-Stromsensor, der dazu geeignet ist, AC- oder DC-Ströme ab 1 mA in einem Frequenzband zwischen 0 Hz und 10 kHz Minimum zu messen, und ein Verarbeitungsmodul beinhaltet, das speziell dazu ausgestaltet ist, das Verfahren nach einem der Ansprüche 1 bis 9 umzusetzen.

## Claims

1. A method for checking the adequacy at the residual currents passing through a differential circuit breaker (12) disposed at the head of an electrical installation (10), by means of a leakage current measuring clamp (30) gripping the active conductors exiting the differential circuit breaker to power a plurality of electrical appliances (14, 16, 18, 20), the method consisting in:
- acquiring over a total acquisition duration (t_{end} - t_{dstart}), at a determined sampling frequency, residual current samples during successive acquisition periods,
- frequency-analyzing by FFT these residual current samples in predetermined frequency bands,
- determining for each frequency band and for each of the successive acquisition periods, a maximum effective current and, at the end of the total acquisition duration, recording the maximum value of the maximum effective currents thus determined in each band frequency, and
- disqualifying or not the differential circuit breaker depending on whether or not this maximum value of the maximum effective currents meets a predetermined compatibility condition and displaying this disqualification or non-disqualification in binary mode by a pictogram on the leakage current measuring clamp.

2. The method according to claim 1, wherein the predetermined frequency bands are the following four: DC ; ]DC - 50Hz[ ; ]60Hz - 1kHz] and ]1kHz - 10kHz].

3. The method according to claim 2, wherein the calculation of the FFT is reduced by determining it only up to 1kHz, the frequency band ]1kHz - 10kHz] being calculated by quadratic subtraction between the total effective current obtained over the entire frequency range [DC - 10kHz] and the sum of the residual current samples obtained in the frequency band ]DC - 1kHz].

4. The method according to claim 3, wherein the calculation of the FFT is preceded by a Hanning or Hamming windowing applied to a determined number of residual current samples.

5. The method according to any one of claims 1 to 5, wherein the use of a differential circuit breaker of the AC, A, or F type which is not recommended is displayed on the leakage current measuring clamp respectively by the following pictograms:

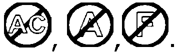

6. The method according to claim 4, wherein the maximum current value in each of the frequency bands defining the predetermined compatibility condition and leading to the disqualification of the differential circuit breaker is given by the following table:
| ***DC*** | ***]DC -* 50Hz[** | ***]60Hz - 1kHz]*** | ***>1kHz*** | ***Displayed pictograms*** |
|---|---|---|---|---|
| *>1mA and <6mA* | any | any | any | 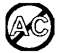 |
| ≥ *6mA and <10mA* | any | any | any | 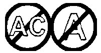 |
| ≥*10mA* | any | any | any | 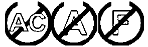 |
| any | >1mA | any | any | 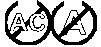 |
| any | any | >1mA | any | 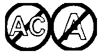 |
| | | ≤ IΔn | | |
| any | any | > IΔn | any | 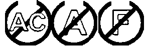 |

7. The method according to any one of claims 1 to 6, wherein the total effective current is calculated by simple quadratic addition of all the residual current samples.

8. The method according to any one of claims 1 to 7, wherein the DC current is calculated by averaging the residual current samples.

9. The method according to any one of claims 1 to 8, wherein each of the successive acquisition periods has a fixed duration of 100ms, the sampling frequency is 81.92kHz and the determined number of samples for the calculation of the FFT is 512.

10. A leakage current measuring clamp including an AC+DC current sensor able to measure AC or DC currents from 1mA, over a frequency band comprised between 0Hz and 10kHz minimum, and a processing module specially configured to implement the method according to any one of claims 1 to 9.
